# EUROPEAN PATENT APPLICATION

(11) **EP 0 735 581 A1**
(43) Date of publication of application: **02.10.1996**
(21) Application number: 96103698.5
(22) Date of filing: 08.03.1996
(51) Int. Cl.: H01L 21/8242

(54) **DRAM trench capacitor with insulating collar**

(30) Priority: 30.03.1995 US 413644
(71) Applicant: SIEMENS AKTIENGESELLSCHAFT, 80333 München (DE)
(72) Inventor: Graimann, Christof, 9500 Villach (AT); Schulz, Angelika, 01109 Dresden (DE); Boit, Christian, 81373 Munich (DE)

(57) **Abstract**

An improved trench cell capacitor (32) within a semiconductor body and methods for producing the same are presented. The improved capacitor, which is suitable for use in 64 Mb DRAMs and other memory cells, comprises a trench cell (21) having doped semiconductor material (38,37) disposed therein, and an oxide isolation collar (24) surrounding the doped material. A thin nitride layer (25) is disposed between the oxide isolation collar and the doped material, resulting in a configuration which provides improved trench cell capacitor processing.

## Description

### FIELD OF THE INVENTION

The present invention relates generally to dynamic random access memory (DRAM) cells and in particular, to an improved trench cell capacitor for DRAM's with buried plate cell architectures.

### BACKGROUND OF THE INVENTION

Buried plated cell architecture for modern DRAMs (64 Mbit and higher) is one of the most promising concepts for improvements in memory technology. As is widely known, a DRAM cell is formed from a transistor and a capacitor. In a buried plate cell, a buried layer of a doped semiconductor material is formed in a substrate beneath the top surface of the DRAM. This buried layer substantially forms one of the capacitor plates of the memory cell. The second capacitor plate is formed within a trench cell adjacent to the buried layer. The trench cell is filled with a doped semiconductor such as polysilicon which forms the second plate of the capacitor. The trench fill material is electrically isolated from the buried layer by means of a dielectric layer surrounding the trench.

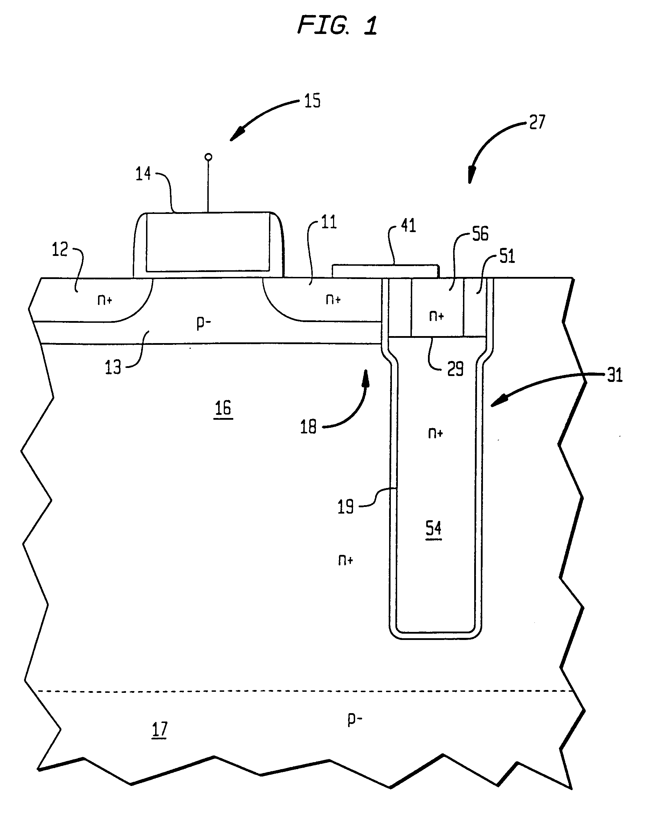

An example of a prior art DRAM cell with a buried plate trench cell architecture is shown in FIG. 1. A p channel field effect transistor 15 includes an n+ drain well 11, n+ source well 12 and p- channel region 13, which has gate 14 disposed thereon. Buried layer 16, here shown doped n+, is disposed within a p- doped substrate 17 beneath the active regions of transistor 15. A trench 31 filled with n+ doped polysilicon 54, 56 penetrates the buried layer 16. A thin dielectric layer 19, typically an oxide layer, surrounds the trench 31 in order to electrically isolate the trench-fill n+ material from the buried layer region 16. In this manner, a trench capacitor 27 is formed in which the n+ polysilicon within trench 31 forms one plate of capacitor 27. Note that buried region 16 has a portion adjacent to the trench region 31. Channel region 13 also has a portion which is adjacent to trench region 31. These adjacent portions of buried region 16 and channel region 13 form the other plate of trench capacitor 27. Dielectric layer 19 thus separates the two plates of trench capacitor 27. The drain well 11 is electrically connected to the trench cell 31 via trench electrode 41. Logic level voltages are thus transferred from the transistor 15 to the trench capacitor 27 which stores the voltage data.

From the structure of FIG. 1, one can ascertain that a vertical parasitic transistor 18 is created between the buried layer 16 and the drain well 11. N+ buried layer 16 acts as the source, p- region 13 acts like the channel region, and n+ well 11 acts as the drain of the parasitic transistor 18. Doped polysilicon 56 acts as the gate, and isolation collar 51 acts as the insulator between the gate and the channel of parasitic transistor 18. The parasitic device 18 must be kept turned off when the trench electrode 41 is at a high logic level voltage. This is accomplished by conveniently forming the isolation collar 51 as a thick oxide or the like, and having it extend down the trench 31 to substantially isolate the adjoining portion of channel region 13 from the doped polysilicon 56.

In a typical trench cell process, the trench 31 is first filled with doped semiconductor material 54 up until a predetermined level near the bottom of the isolation collar 51. This level is indicated by the cross-sectional depth line 29 in FIG. 1. After the first fill, the isolation collar 51 is formed, which may be a thick oxide layer such as tetra-ethyl-ortho-silicate (TEOS). The trench 31 is then filled with another "plug" 56 of the same doped semiconductor material from line 29 to the top surface. Thus, in order to incorporate the benefits of a thick isolation collar, two "plugs" of n+ polysilicon or similar material are needed to fill the trench 31.

Other examples of prior art DRAM trench cells which have isolation collars are described in U.S. Patent No. 4,794,434 entitled "Trench Cell for a DRAM", issued on December 27, 1985 to P. Pelley III. This patent discloses trench cells filled with either n+ or p+ polysilicon and describes a technique for raising the potential of the buried layer in order to reduce the maximum voltage which will be developed across the insulating layer.

The oxide isolation collar technique, while affording a number of advantages, suffers from several drawbacks in the course of subsequent processing. One problem is that subsequent high temperature steps will diffuse oxygen through top layers and eventually through the collar. This will lead to trench sidewall silicon oxidation and to poly oxidation, i.e., "trench poly-fill". The oxygen diffusion results in volume expansion which in turn can lead to the introduction of stacking faults and dislocations through stress generation.

Another problem is that contaminants outdiffusing from a TEOS collar may contribute to interface problems between the two semiconductor fill layers within the trench. This can lead to severe contact problems of the trench electrode. An additional problem is that outdiffusion of dopants from the highly doped trench polysilicon fill through the collar is possible in the case of disrupted or otherwise damaged collars.

Accordingly, it is an object of the present invention to provide an improved trench cell capacitor for a DRAM which overcomes the problems of the prior art.

It is a further object of the instant invention to provide an improved isolation collar of a DRAM trench cell capacitor which has a nitride liner for avoiding the problems associated with prior art isolation collars.

It is yet another advantage of the present invention to provide improved processes for forming an isolation collar in a DRAM trench cell.

These and other objects and advantages of the instant invention will become apparent to those of ordinary skill in the art having reference to the following detailed description of an exemplary embodiment thereof.

### SUMMARY OF THE INVENTION

The instant invention is an improved trench cell capacitor within a semiconductor body, suitable for use in a 64KB DRAM memory cell or in other similar memory cells. The improved trench cell capacitor includes a trench cell with doped semiconductor material disposed therein, an oxide isolation collar of a predetermined thickness surrounding the doped semiconductor material, and a nitride layer disposed between the oxide isolation collar and the doped semiconductor material. The nitride layer has a thickness less than the predetermined thickness of the isolation collar.

The inclusion of the nitride layer between the isolation collar and the doped material solves a number of processing problems associated with prior art trench cell capacitors having isolation collars.

Optionally, the improved trench cell capacitor may have a second oxide layer disposed between the nitride layer and the doped semiconductor material.

The trench cell of the capacitor may have a first region and a second region, with the isolation collar and the nitride layer being situated within the first region, and the doped semiconductor material being disposed in both of the first and second regions. A dielectric insulating layer having a thickness less than the predetermined thickness of the isolation collar surrounds the doped semiconductor material within the second region and also forms a bottom of the trench cell. The trench capacitor preferably has a buried layer of doped semiconductor material adjacent to the trench cell to substantially form one plate of the trench capacitor, wherein the doped semiconductor material disposed within the first and second regions of the trench cell forms a second plate of the capacitor, and the dielectric layer separates the plates of the capacitor.

The present invention also teaches a method of fabricating an improved trench cell capacitor within a semiconductor body. The method comprises the steps of: forming a trench within a semiconductor substrate; depositing an oxide layer of a predetermined thickness on exposed walls within the trench and on an exposed major surface within the trench; depositing a nitride layer over exposed portions of the oxide layer, where the nitride layer has a thickness less than the predetermined thickness; etching away a portion of the nitride layer and of the oxide layer covering the major surface to expose a portion of the major surface; and filling the trench with doped semiconductor material to substantially fill the trench.

This method may further include the steps of: lining a portion of the trench with a dielectric layer of a given thickness after the trench is formed within the semiconductor substrate, where the given thickness is less than the predetermined thickness; filling the trench to a predetermined level with doped semiconductor material to substantially form the major surface at the predetermined level, the major surface thereby including exposed doped semiconductor material.

The present invention also teaches a method of fabricating a trench cell capacitor within a semiconductor body, comprising the steps of: forming a trench within a semiconductor body; depositing an oxide layer of a predetermined thickness on exposed walls within the trench and on an exposed major surface within the trench; etching away a portion of the oxide layer covering the major surface to expose a portion of the major surface; depositing a nitride layer over exposed portions of the oxide layer and on the exposed portion of the major surface; etching away a portion of the nitride layer covering the major surface to again expose a portion of the major surface; and filling the trench with doped semiconductor material to substantially fill the trench.

### BRIEF DESCRIPTION OF THE DRAWINGS

For a better understanding of the instant invention, reference is made to the following description of an exemplary embodiment thereof, considered in conjunction with the accompanying drawings, in which:
FIG. 1 shows a cross section of a trench cell capacitor type DRAM memory cell of the prior art;
FIG. 2 shows a cross section of an exemplary embodiment of a trench cell capacitor type memory cell according to the present invention;
FIGs. 3-4 illustrates process steps in the manufacture of a memory cell according to the instant invention; and
FIGs. 5-8 illustrate an alternate sequence of process steps in the manufacture of a memory cell according to the present invention.

### DETAILED DESCRIPTION OF THE INVENTION

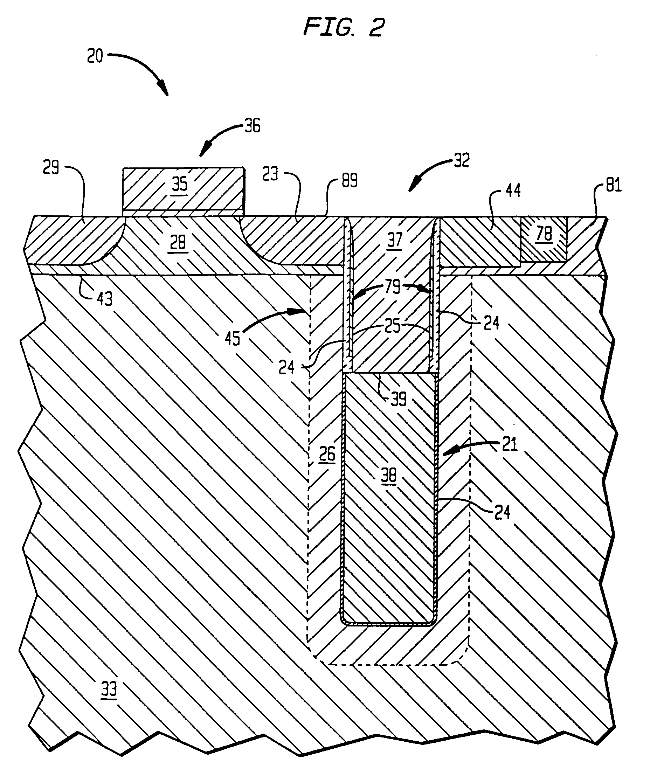

A preferred embodiment of an improved DRAM according to the instant invention is shown in cross section in FIG. 2. A DRAM 20 includes a transistor 36 and a trench capacitor 32 coupled to transistor 36, for storing data. Trench capacitor 32 includes a trench cell 21 which has a thick oxide isolation collar 24 formed peripherally along its upper sidewalls. A thin nitride liner 25 is disposed on the inner sidewalls of the oxide collar 24. This thin nitride liner 25 is an important feature of the instant invention, as will be described below.

The DRAM 20 may be formed by growing epitaxial layers on a doped semiconductor substrate 33, as is well known in the art. A buried layer 26, typically highly doped, is formed within the substrate 33 either by selective ion implantation or by epitaxial growth. Forming a buried layer in a semiconductor substrate is known in the art. For example, a lower portion of buried layer 26 may be formed within substrate 33 and an upper portion of buried layer 26 may be formed within an epitaxial layer (not shown). In any event, depth line 43 shows the separation between the buried layer 26 and the channel region 28 of the transistor 36. Also shown is drain well 23, source well 29 and gate 35, which together with channel region 28 comprise the transistor 36. DRAM 20 also includes contact region 44, doped region 81 and oxide isolation region 78.It is noted that channel region 28 also extends beneath source and drain wells 29 and 23. Channel region 28 is preferably of opposite conductivity as the buried layer 26. As a result, isolation is provided between the buried layer 26 and the source and drain regions 29 and 23. Exemplary doping conductivities are: substrate 33, p- conductivity; buried layer 26, n+ ; channel 28, p- ; drain and source regions 33 and 29, n+; contact region 44, n+; doped region 81, p-. The transistor 36 thus formed would then be a p channel FET. In any event, the instant invention may just as readily be implemented using an n channel FET. In either case, a side effect of the vertical structure is the formation of a parasitic transistor 45 formed between buried layer 26, drain well 23 and the portion of channel region 28 between regions 23 and 26.

The trench cell 21 of capacitor 32 is formed within the buried layer 26. While trench cell 21 may be substantially cylindrical, it may also be formed with a truncated cone-like shape with the wide portion of the cone being at the top surface. The diameter of the trench cell cone would then taper down to a given diameter at a predetermined depth. Trench cell 21 may also have a square or rectangular platform. It is seen that the cross-sectional view of FIG. 2 corresponds to either a cylindrical trench or a trench with a square or rectangular platform. Whether the trench cell is substantially cylindrical or otherwise, the very bottom of the trench could be formed so that it is recessed out at the bottom to improve punchthrough characteristics.

A thin dielectric layer 22 is disposed along the bottom of the trench and peripherally along the bottom sidewalls of the trench up to a predetermined level, as indicated by depth line 39. Dielectric layer 22 may alternatively extend all the way to the top surface 89 of the DRAM 20 instead of ending at line 39 (this embodiment is omitted from FIG. 2.) This dielectric layer 22 may be silicon dioxide (SiO₂) such as a thermal oxide or TEOS oxide. If the trench cell 21 is formed with a recessed out portion (not shown) at the bottom of the trench, then the oxide layer at the trench bottom would be thicker than that along the sidewalls. This increased oxide thickness at the trench bottom is advantageous because this area is more vulnerable to punchthrough, as has been found in the prior art.

The trench 21 is filled with a first "plug" 38 of doped polysilicon to the same level as that of the thin oxide layer 22, i.e., to line 39. With transistor 36 embodied as a p channel FET, as in the above example, plug 38 is preferably doped n+. In an n channel FET embodiment, plug 38 would be doped p type and buried layer 26 would also preferably be p type. A second polysilicon plug 37, preferably of the same doping level as the first plug 38, fills the remainder of the trench cell 21. However, this second plug 37 is inserted in the trench after the thick oxide collar 24 and nitride collar 25 are formed, as will be described below.

Polysilicon plugs 38 and 37 thus form one plate of trench cell capacitor 32. Now, buried layer 26 has a portion which adjoins trench cell 21. Channel region 28 also has a portion adjoining trench cell 21. The combination of these adjoining portions of buried layer 26 and channel 28 form the other plate of capacitor 32, with the substantial contribution coming from the buried plate adjoining portion. The adjoining portion of channel 28 contributes very little to the capacitance. Thin dielectric layer 22 thus separates the plates of the capacitor 32. The thinner dielectric layer 22 is made, the higher the capacitance. However, layer 22 must be made thick enough to ensure that no dielectric breakdown will occur.

After the first polysilicon plug 38 is inserted in the trench 21, thick oxide collar 24 with nitride liner 25 is formed peripherally along the inside perimeter the trench 21 from line 39 to the top surface 89 of capacitor 32. Now, a parasitic transistor 45 is formed as follows: buried layer 26 acts as the drain, drain region 23 acts as the source, polysilicon 37 behaves as the gate, and the portion of channel region 28 between regions 23 and 26 acts as the channel region for parasitic transistor 45. Oxide collar 24 with nitride liner 25 behaves as the insulator between the gate and the channel of parasitic transistor 45. The combination of the thickness of oxide collar 24, which functions to increase the threshold voltage of the parasitic device, and the low conductivity doping of channel region 28, insures that parasitic transistor 45 is not conductive.

An additional purpose of the thick oxide collar 24 is to assure that there is no dielectric breakdown or punchthrough between polysilicon 37 and region 28. Dielectric breakdown or punchthrough would otherwise be a possibility whenever a high differential voltage is present between polysilicon 37 and the portion of channel 28 that adjoins the trench 21.

The addition of the nitride layer or "liner" 25 on the inner sidewalls of oxide isolation collar 24 affords several key advantages over a trench cell capacitor without such a nitride liner. Firstly, subsequent high temperature processing and high temperature oxidation is customarily performed after the formation of the isolation collar 24. The nitride liner 25 prevents excess oxidation of the trench-fill polysilicon (plugs 37 and 38) which would otherwise occur during the subsequent processing. Second, nitride liner 25 also prevents trench sidewall bulk silicon oxidation that would otherwise occur during the high temperature oxidation. Third, bulk silicon oxidation and excess trench-fill polysilicon oxidation would typically lead to stress induced defect generation, which is now also prevented by nitride liner 25. Fourth, nitride liner 25 functions to prevent outdiffusion of dopants from the highly doped regions 37 and 38 through "weak" regions of the isolation collar 24 into the vertical parasitic device 45. This outdiffusion would typically undesirably turn on the parasitic device 45 or cause it to exhibit leakage, problems which are now prevented by the nitride liner 25. Finally, nitride liner 25 prevents interface contamination between trench fill polysilicon plugs 38 and 37. This is accomplished by the nitride liner 25 hindering outdiffusion and outgassing of contaminants such as oxygen from the isolation collar region during trench polysilicon fill with plug 37 and associated processing.

It is noted that trench cell 21 may have another thin oxide liner (omitted from FIG. 2 for convenience) disposed peripherally on the inner sidewalls 79 of nitride liner 25, i.e., between nitride liner 25 and polysilicon plug 37. This thin oxide liner may be formed by heat treating the nitride liner 25 at a high temperature such as, for example, 900° Celcius under a steam atmosphere. With liner 25 comprised of silicon nitride, a thin layer of the inner walls of nitride liner 25 is converted to SiO₂ by this heat treatment to form the thin oxide liner.

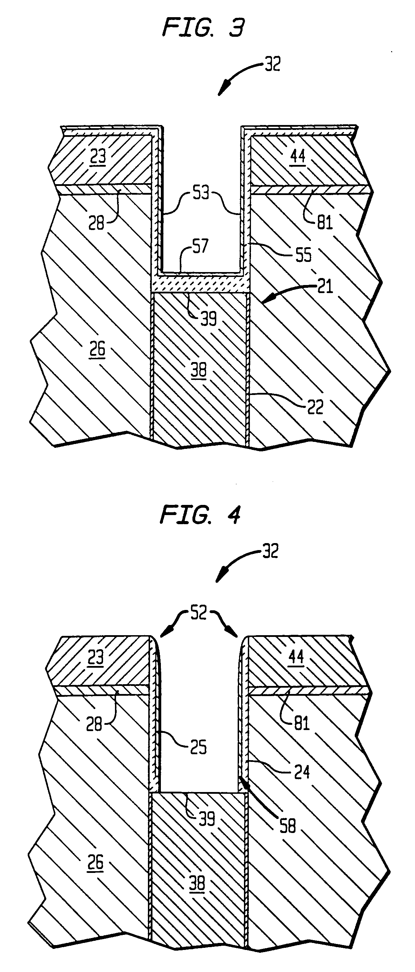

Referring now to FIGs. 3 and 4, one sequence of steps in the formation of the thick oxide collar 24 and thin nitride collar 25 is illustrated. After the thin oxide layer 22 is formed and first silicon plug 38 is formed or inserted within trench 21, a thick oxide layer 55 is formed, as shown in FIG. 3. Oxide layer 55 is formed to cover a major surface indicated by line 39, consisting of the top surfaces of first silicon plug 38 and of thin dielectric layer 22. Layer 55 extends peripherally along the upper sidewalls of trench 21 and along the top surfaces of wells 23 and 44. Thick oxide layer 55 may be a silicon dioxide which is preferably a TEOS oxide, but may also be a thermal oxide.

A thin nitride layer 57 is then deposited to cover all exposed areas of thick oxide layer 55 within trench 21 along the sidewalls and above line 39, and also to cover exposed areas above regions 23 and 44, as shown. Nitride layer 57 is preferably a silicon nitride such as Si₃N₄ and deposited either by low pressure chemical vapor phase deposition (LPCVD), by CVD, or by PECVD or other appropriate method. An exemplary thickness of nitride layer 55 would be in the range of 70-180 angstroms. An exemplary thickness of oxide layer 55 is preferably three to five times the thickness of the nitride layer. It is noted that thin dielectric layer 22 may be about the same thickness as the nitride layer 55, i.e., 70-180 Angstroms.

The portions of nitride layer 57 and thick oxide layer 55 disposed on the top surface of polysilicon plug 38 and within the inner sidewalls of nitride layer 56 (i.e., as indicated by boundaries 53, in cross section) are then etched away. Standard photomasking and photoetching techniques may be used. The layers above regions 23 and 44 are also etched away. Thick oxide collar 24 with thin nitride liner 25 are thus formed, as shown in FIG. 4. Precautions must be taken during the etching process to prevent the portion of nitride layer 57 that is disposed on the inner sidewalls of oxide layer 55 from being substantially consumed. Photoetching is also used to peripherally etch back oxide layer 24 and nitride liner 25 from the top surface down, to form a peripherally tapered region 52. This allows the second polysilicon plug 37 (shown in FIG. 2), which is subsequently formed or inserted, to be situated closer to drain region 23, thereby facilitating electrical contact between the two regions. The etching back technique thus obviates the need for an additional electrode between the trench polysilicon plug 37 and drain 23 by enabling a direct electrical connection between the two regions, or, allows for the use of a physically smaller electrode.

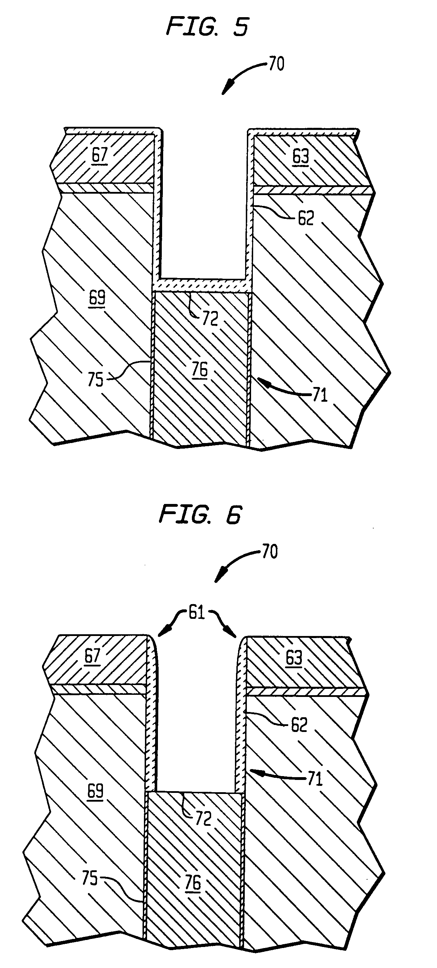

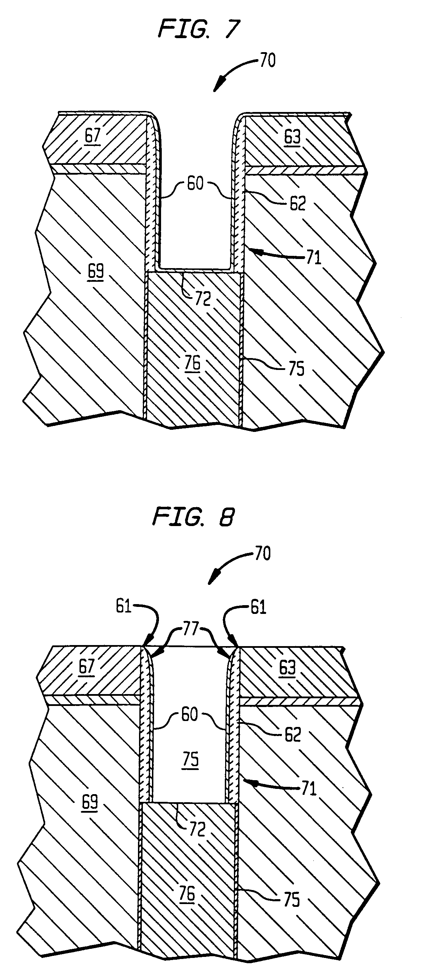

An alternative method of forming a thick oxide collar with thin nitride liner within a DRAM trench cell capacitor according to the instant invention is illustrated in FIGs. 5-8. FIG. 5 shows a trench capacitor 70 comprising a trench cell 71 formed within a buried layer 69. The bottom portion of trench 71 is lined peripherally with a thin dielectric layer 75, and filled with a first highly doped polysilicon plug 76 up to a predetermined depth line 72. A thick oxide layer 62 such as TEOS is then formed along the upper sidewalls of trench 71, and on a major surface consisting of the top surfaces of polysilicon plug 76 and thin oxide layer 75, which is indicated by depth line 72. Oxide layer 62 is also formed to extend on the top surfaces of drain region 67 and doped region 63. Layer 62 is then "spacer" etched away in the region above depth line 72 such that only the thick oxide sidewalls remain, as shown in FIG. 6. The portion of thick oxide layer 62 above regions 67 and 63 are also etched away and the top portion etched back to form a peripherally tapered region 61.

A thin nitride layer 60 is then applied within trench 71 to completely cover thick oxide layer 62, as shown in FIG. 7. An exemplary thickness of nitride layer 60 would be 70 to 180 Angstroms. Thick oxide layer 62 may be, for example, three to five times the thickness of nitride layer 60. Dielectric layer 75 is preferably about the same order of thickness of nitride layer 60. Nitride layer 60, which may be silicon nitride Si₃N₄ deposited by LPCVD, CVD, PECVD or other appropriate method, initially covers the top surfaces of regions 67 and 63 and the exposed surface of polysilicon plug 76, corresponding to depth line 72. The nitride layer covering these latter surfaces are then spacer etched away, resulting in the configuration of FIG. 8. A tapered nitride layer region 77 is also formed in proximity to tapered oxide region 61 via the spacer etching. This allows drain region 67 to be situated closer to a second highly doped polysilicon plug 75, which is formed or inserted within trench cell 71 as the last step in the process. Electrical contact between the two regions is thereby facilitated or may be accomplished directly.

In the structure of FIG. 8, the resulting nitride liner 60 extends all the way down to the first polysilicon plug 76 at depth line 72. This is slightly different than the structure of FIG. 4 which was the result of the first described process according to the present invention. In FIG. 4, the nitride liner 25 extends down to a depth 58 which is slightly shallower than the depth of oxide collar 24. Although the configurations of FIGs. 4 and 8 are thus distinguishable, the performance characteristics of the two different trench capacitors are substantially the same.

The alternate described process corresponding to FIGs. 5-8 has one advantage over the process of FIGs. 3-4. That is, consumption of the nitride layer 60 is more easily avoided by etching the oxide layer disposed on the major polysilicon surface in a separate step, i.e., as shown in FIG. 6. In the first described process of FIGs. 3-4, the portion of the nitride layer 57 disposed on the sidewalls of oxide layer 55, may be undesirably subjected to relatively more etching in order to etch away the oxide layer disposed on plug 38. Thus, this sidewall portion of nitride layer 57 is more easily consumed. On the other hand, the process of FIGs. 5-8 involves more steps, and hence, it is necessary for the trench capacitor designer to perform a tradeoff between the two processes.

Experimental results demonstrate the advantage of the improved trench capacitor of the present invention. An experiment was performed on product lots of 128K DRAM memory blocks having isolation collars with and without nitride liners. Results indicated a 30% wafer yield improvement for the memory blocks having the nitride liner over those that did not.

Thus disclosed is an improved trench cell capacitor suitable for use in DRAM memory cells, which has an isolation collar with a nitride liner, and, methods for producing the same. A first advantage of the capacitor according to the instant invention is that excess oxidation of trench-fill doped polysilicon is prevented during high temperative processing subsequent to isolation collar formation. Another advantage of this invention is that trench sidewall bulk silicon oxidation is prevented during high temperature oxidation. A further advantage of the present invention is that, by preventing unwanted oxidation, the generation of stress induced defects are in turn prevented. An additional advantage of this invention is that it prevents the outdiffision of dopants through "weak" collar regions into regions of a vertical parasitic device adjacent to the trench cell capacitor, which would otherwise be turned on or exhibit leakage. Yet another advantage of the instant invention is that contamination of the interface between two polysilicon "plugs" that fill the trench cell of the capacitor is prevented. The invention prevents this contamination by hindering outdiffusion and outgassing of contaminants such as oxygen from the isolation collar region during the trench poly-fill and processing that occurs after the isolation collar is formed.

It should be understood that the embodiments described herein are merely exemplary and that a person skilled in the art may make many variations and modifications without departing from the spirit and scope of the invention. All such modifications are intended to be included within the scope of the invention as defined by the appended claims.

## Claims

1. A trench cell capacitor within a semiconductor body, comprising:
a trench cell having doped semiconductor material disposed therein;
an oxide isolation collar of a predetermined thickness surrounding said doped semiconductor material; and
a nitride layer disposed between said oxide isolation collar and said doped semiconductor material, said nitride layer having a thickness less than said predetermined thickness.

2. The capacitor according to Claim 1 wherein said isolation collar comprises a TEOS oxide.

3. The capacitor according to Claim 1 wherein said nitride layer is comprised of Si₃N₄.

4. The capacitor according to Claim 1 further comprising a second oxide layer disposed between said nitride layer and said doped semiconductor material.

5. The capacitor according to Claim 1 wherein said isolation collar is a SiO₂ thermal oxide.

6. The capacitor according to Claim 1 wherein said trench cell further comprises:
a first region and a second region, with said isolation collar and said nitride layer being situated within said first region, said doped semiconductor material being disposed in both of said first and second regions; and
a dielectric insulating layer having a thickness less than said predetermined thickness, surrounding said doped semiconductor material within said second region and forming a bottom of said trench cell.

7. The capacitor according to Claim 6 further comprising a buried layer of doped semiconductor material adjacent to said trench cell to substantially form one plate of said trench capacitor, wherein said doped semiconductor material disposed within said first and second regions of said trench cell forms a second plate of said capacitor, said dielectric layer separating said plates of said capacitor.

8. The capacitor according to Claim 7 wherein said buried layer is formed by ion implantation into a semiconductor substrate.

9. The capacitor according to Claim 6 wherein said buried layer comprises a third region and a fourth region, said third region being disposed within a semiconductor substrate and said fourth region being disposed within an epitaxial layer grown on said semiconductor substrate.

10. The capacitor according to Claim 6 wherein said dielectric layer is comprised of SiO₂.

11. A memory cell within a semiconductor body, comprising:
a transistor having a gate and a conduction path;
a trench cell capacitor having a trench cell with doped semiconductor material disposed therein, an isolation collar of a predetermined thickness surrounding said doped semiconductor material and a nitride layer disposed between said isolation collar and said semiconductor material;
wherein a portion of said conduction path adjoins said trench cell, said conduction path being coupled to said doped semiconductor material within said trench cell.

12. The memory cell according to Claim 11 wherein said isolation collar has a top portion adjacent to said conduction path, said isolation collar having a thickness which is tapered as a function of depth such said top portion of said isolation collar has a thickness that is less than the thickness of a remainder of said isolation collar, thereby allowing said doped semiconductor material in proximity to said top portion within said trench to be positioned closer to said conduction path of said transistor.

13. A method of fabricating a trench cell capacitor within a semiconductor body, comprising the steps of:
forming a trench within a semiconductor substrate;
depositing an oxide layer of a predetermined thickness within said trench;
depositing a nitride layer on said oxide layer, said nitride layer having a thickness less than said predetermined thickness; and
filling said trench with doped semiconductor material to substantially fill said trench.

14. The method according to Claim 13 wherein said oxide layer of a predetermined thickness is deposited within said trench on exposed walls of said trench and on an exposed major surface within said trench; said nitride layer is deposited on exposed portions of said oxide layer; and further comprising the step of etching away a portion of said nitride layer and a portion of said oxide layer disposed on said major surface to expose a portion of said major surface.

15. The method according to Claim 14 further comprising the steps of:
lining a portion of said trench with a dielectric layer of a given thickness after said trench is formed within said semiconductor substrate, said given thickness being less than said predetermined thickness; and
filling said trench to a predetermined level with doped semiconductor material to substantially form said major surface at said predetermined level, said major surface thereby including exposed doped semiconductor material.

16. The method according to Claim 14 further comprising the step of:
etching away a top portion of said oxide layer and of said nitride layer, said top portion of said oxide layer being disposed on said walls of said trench, wherein said oxide layer and said nitride layer are tapered as a function of depth such that said top portion of said oxide layer has a thickness that is less than a remaining portion of said oxide layer and such that said top portion of said nitride layer has a thickness that is less than a remaining portion of said nitride layer.

17. The method according to Claim 13 further comprising the step of subjecting said nitride layer to a heat treatment such that an exposed surface of said nitride layer is converted to a second oxide layer.

18. The method according to Claim 13 wherein said nitride layer is Si₃N₄ deposited by chemical vapor deposition (CVD).

19. The method according to Claim 13 wherein said oxide layer of a predetermined thickness is deposited on exposed walls of said trench and on an exposed major surface within said trench; a portion of said oxide layer covering said major surface is etched away to expose a portion of said major surface; said nitride layer is deposited within said trench over exposed portions of said oxide layer and on said exposed portion of said major surface; and a portion of said nitride layer deposited on said major surface is etched away to again expose a portion of said major surface.

20. The method according to claim 19 further comprising the steps of:
lining a portion of said trench with a dielectric layer of a given thickness after said trench is formed within said semiconductor substrate, said given thickness being less than said predetermined thickness;
filling said trench to a predetermined level with doped semiconductor material to substantially form said major surface at said predetermined level, said major surface thereby including exposed doped semiconductor material.

21. The method according to Claim 14 wherein said oxide layer of a predetermined thickness is deposited on exposed walls of said trench and on an exposed major surface within said trench; a portion of said oxide layer covering said major surface is etched away to expose a portion of said major surface; said nitride layer is deposited within said trench over exposed portion of said major surface; and a portion of said nitride layer deposited on said major surface is etched away to again expose a portion of said major surface.

22. The method according to claim 21 further comprising the steps of:
lining a portion of said trench with a dielectric layer of a given thickness after said trench is formed within said semiconductor substrate, said given thickness being less than said predetermined thickness;
filling said trench to a predetermined level with doped semiconductor material to substantially form said major surface at said predetermined level, said major surface thereby including exposed doped semiconductor material.
